# EUROPEAN PATENT SPECIFICATION

(11) **EP 4 246 588 B1**
(45) Date of publication and mention of the grant of the patent: **30.07.2025**
(21) Application number: 23162457.8
(22) Date of filing: 16.03.2023
(51) Int. Cl.: H10D 8/00, H10D 64/00, H10D 62/10

(54) **DIODE AND POWER CIRCUIT**
DIODE UND LEISTUNGSSCHALTUNG
DIODE ET CIRCUIT DE PUISSANCE

(30) Priority: 16.03.2022 CN 202210257512
(43) Date of publication of application: 20.09.2023
(73) Proprietor: Huawei Digital Power Technologies Co., Ltd., Shenzhen, Guangdong 518043 (CN)
(72) Inventor: YANG, Wentao, Shenzhen, 518043 (CN); WANG, Kang, Shenzhen, 518043 (CN); NING, Runtao, Shenzhen, 518043 (CN); YE, Shizhuo, Shenzhen, 518043 (CN); LIU, Peng, Shenzhen, 518043 (CN)
(74) Representative: Gill Jennings & Every LLP

(56) References cited:
- US-A- 5 969 400
- US-A1- 2002 134 998
- US-A1- 2020 295 178
- US-B1- 6 177 713
- US-B1- 8 466 492

## Description

### TECHNICAL FIELD

This application relates to the field of semiconductor technologies, and in particular, to a diode and a power circuit.

### BACKGROUND

A diode (diode) is a common semiconductor device that can be used as a power device in power electronics. In particular, a fast recovery diode (FRD) has advantages such as high on-state current density, low loss, and good stability, and is widely used in fields such as power grid, transportation, communication, photovoltaic, and household appliances. For example, the fast recovery diode may be combined with an insulated gate bipolar transistor (IGBT) to be used as a switching element in an inverter circuit, to convert a direct current into an alternating current, thereby driving a motor (motor) to operate.

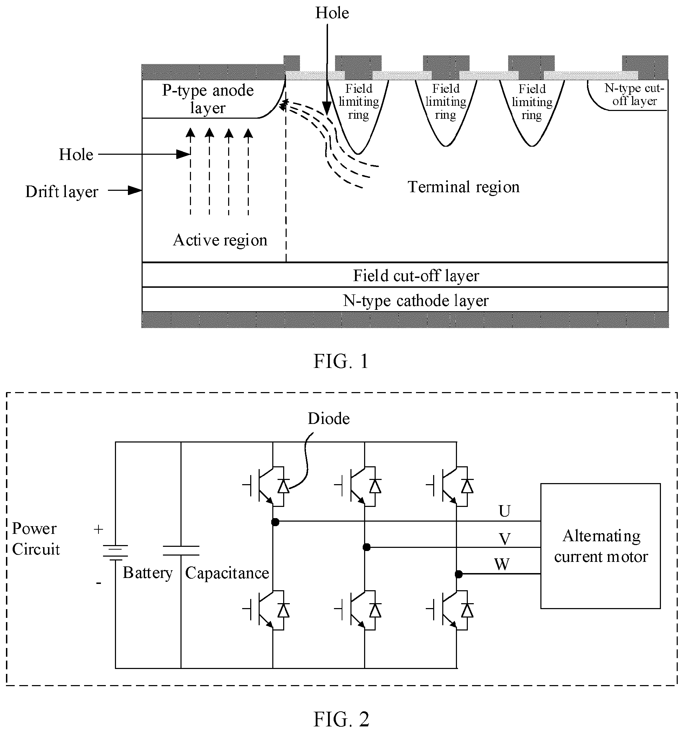

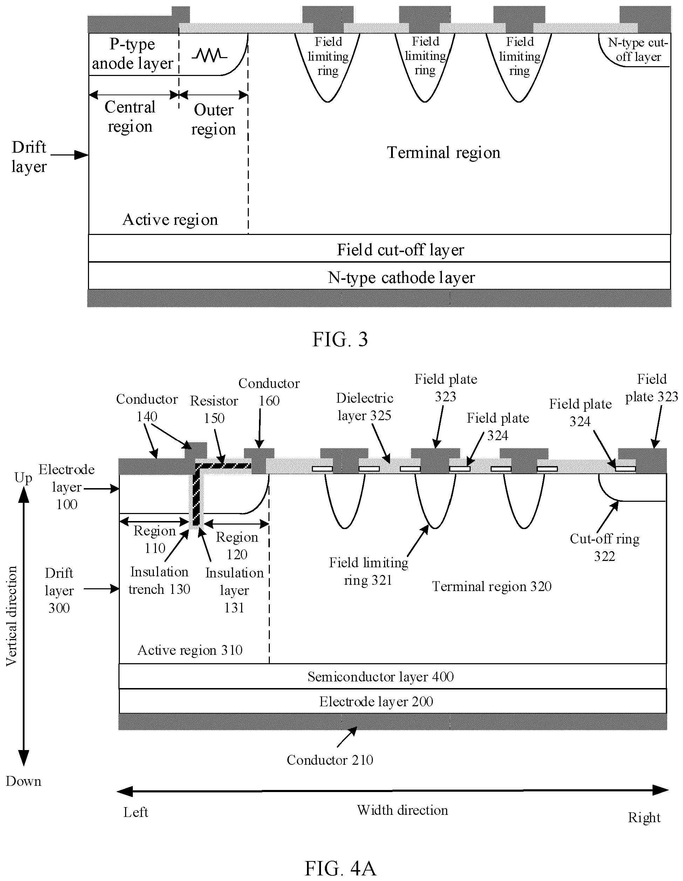

FIG. 1 shows a conventional structure of a diode. When the diode is positively conducted (energized), a P-type anode layer injects a large quantity of holes into a drift layer (drift layer), and an N-type cathode layer injects a large quantity of electrons into the drift layer. Therefore, during conduction, the drift layer stores a large quantity of electron-hole pairs. When the diode is off (cut off), the holes stored in the drift layer are extracted through the P-type anode layer. A large quantity of holes stored in a terminal region of the drift layer are extracted through a curved edge of the P-type anode layer. As a result, currents of the curved edge are concentrated, so that a temperature of the curved edge rises sharply. In addition, curvature effect existing in the curved edge causes an electric field to concentrate, thereby generating an avalanche, so that currents of the curved edge are further concentrated, and the temperature of the curved edge is further increased. Therefore, the curved edge is easily burnt, and the diode fails.
US8466492 describes a semiconductor device which includes a semiconductor body including a first surface, an inner region and an edge region, a first doped device region of a first doping type in the inner region and the edge region, a second device region forming a device junction in the inner region with the first device region, and a plurality of at least two dielectric regions extending from the first surface into the semiconductor body.
US5969400 describes a semiconductor device which includes a first semiconductor layer of a first conductivity type having first and second main surfaces, a second semiconductor layer of a second conductivity type selectively formed on the first main surface of the first semiconductor layer, the second semiconductor layer including a first region having a relatively high injection efficiency and a second region having a relatively low injection efficiency.
US6177713 describes an anode electrode metal layer composed of aluminum formed in a region on the inner side than an anode layer formed on a main surface of a semiconductor substrate, a structure similar to the one shown in Fig. 3 of the present application.
US2002/134998 describes a semiconductor device, such as a power MOSFET, Schottky rectifier or p-n rectifier, which has a voltage-sustaining zone between a first and second device regions adjacent to respective first and second opposite surfaces of a semiconductor body.
US2020/295178 describes an insulation film which includes a first opening portion in at least one of a cell region and a termination region, and a second opening portion in an interface region.

### SUMMARY

The present invention is defined by the appended claims. Embodiments of this application provide a diode and a power circuit. The diode has a low burning risk and high reliability, and further improves reliability of the power circuit.

According to a first aspect, a diode according to claim 1 is provided.

The first electrode layer may be used as a cathode region of the diode, and the second electrode layer may be used as an anode region of the diode. Alternatively, the first electrode layer may be used as an anode region of the diode, and the second electrode layer may be used as a cathode region of the diode.

Doped impurities of a same property means that types of doped impurities are the same. It may be understood that, for a semiconductor, impurities may be classified into an N (negative) type impurity used to provide an electron and a P (positive) type impurity used to provide a hole. The doped impurities of a same property means that doped impurities of the same property or type, and are both the N-type impurity or P-type impurity. The drift layer and the first electrode layer being doped with impurities of a same property means that the drift layer is doped with the N-type impurity, and the first electrode layer is doped with the N-type impurity, or the drift layer is doped with the P-type impurity, and the first electrode layer is doped with the P-type impurity. Relatively, doped impurities of different properties means that types of doped impurities are different. Specifically, when the drift layer and the electrode layer are doped with impurities of different properties, if one of the drift layer and the first electrode layer is doped with the N-type impurity, the other is doped with the P-type impurity, or if one of the drift layer and the first electrode layer is doped with the P-type impurity, the other is doped with the N-type impurity.

The terminal region is a part of the drift layer of the diode that surrounds the active region. That is, the drift layer of the diode includes an active region and a terminal region, where the terminal region surrounds the active region. The terminal region may be used to alleviate curvature effect of an electric field at an edge of the active region, and increase a breakdown voltage of the diode.

The first conductor and the second conductor refer to two objects that have low resistivity and are easy to conduct a current, for example, metals and the like. A specific material of the first conductor and a specific material of the second conductor may be the same, for example, both are tungsten. A specific material of the first conductor and a specific material of the second conductor may also be different. For example, the material of the first conductor is tungsten, and the material of the second conductor is aluminum. The first conductor and the second conductor are located at different positions in the diode. Specifically, the first conductor is located above the first region, and is configured to implement a connection between the first region and the power supply. The second conductor is located above the second region, and is configured to implement a connection between the second region and the power supply, where the connection between the second region and the power supply is specifically that the second region is connected to the power supply through the second conductor, the first resistor, and the first conductor sequentially.

In the diode, the first region and the second region in the second electrode layer are separated by an insulation trench. The first region may be connected to a power supply through the first conductor, to ensure a conduction characteristic of the diode. The second region is connected to the power supply through the second conductor, the first resistor, and the first conductor sequentially, so that when the diode is on, the first resistor may reduce an electric potential of the second region, that is, the electric potential of the second region is lower than an electric potential of the first region. Therefore, efficiency of injecting a carrier into the drift layer through the second region is reduced, so that when the diode is off, a quantity of carriers that are extracted through the second region is small, current density of the second region is reduced, and current concentration in the second region is suppressed. Further, a risk that the diode is burned caused by the current concentration in the second region is suppressed, and reliability of the diode is improved.

In addition, when the diode is off, and when a carrier passes through the second region and flows through the first resistor, an electric potential of the first resistor may be increased. Therefore, an electric potential difference between the second region and the first electrode layer is reduced, and the carrier that passes through the second region is further reduced. Further, a risk that the diode is burned caused by the current concentration in the second region is further suppressed, and reliability of the diode is improved.

In addition, the second region is connected to the power supply by the first resistor. A material and/or a wiring length of the first resistor may be selected to adjust a capability of the first resistor to block the carrier. Therefore, the capability of the first resistor to block the carrier can be improved without occupying an excessively much area of the second electrode layer, thereby ensuring an area of the first region, and further ensuring the conduction characteristic of the diode.

In a possible implementation, a depth by which the second region extends into the active region is greater than a depth by which the first region extends into the active region.

In this implementation, a junction depth of the second region is greater than a junction depth of the first region, that is, the junction depth of the second region is large, an interface between the second region and the drift layer is increased, an electric field at the interface between the second region and the drift layer may be dispersed, and current concentration at the interface between the second region and the drift layer is reduced. Therefore, heat generation at the interface between the second region and the drift layer is suppressed, a risk that the diode is burned is reduced, and diode reliability is further improved.

In a possible implementation, the first region includes a plurality of third regions on the active region, and adjacent third regions in the plurality of third regions are separated by a second insulation trench, where a depth by which the second insulation trench extends into the active region is greater than a depth by which the third region extends into the active region.

In this implementation, the first region is divided into a plurality of third regions by a second insulation trench, and a depth by which the second insulation trench extends into the active region is greater than a depth by which the third region extends into the active region. Therefore, when the diode is in an on state, the second insulation trench may block or slow down migration of a carrier in the third region to the terminal region, thereby reducing a quantity of carriers in the terminal region. Therefore, when the diode is off, a quantity of carriers that are extracted through the second region is also small, current concentration in the second region is further reduced, and heat generation in the second region is suppressed, so that a risk that the diode is burned is reduced, and reliability of the diode is further improved.

In a possible implementation, a barrier layer is disposed between the first region and the active region, and the barrier layer is configured to slow down migration of the carrier between the first region and the active region.

In this implementation, a barrier layer is disposed between the first region and the active region. When the diode is in an on state, the barrier layer may slow down migration of the carrier in the first region to the active region, thereby reducing the carrier diffused to the terminal region, and reducing a quantity of carriers in the terminal region. Therefore, when the diode is off, a quantity of carriers that are extracted through the second region is also small, current concentration in the second region is further reduced, and heat generation in the second region is suppressed, so that a risk that the diode is burned is reduced, and reliability of the diode is further improved.

In a possible implementation, the first resistor is polycrystalline silicon.

In this implementation, the first resistor may be prepared by using polycrystalline silicon. A preparation process is simple, and an electric potential of the second region may be effectively reduced.

In a possible implementation, a first semiconductor layer is disposed between the drift layer and the first electrode layer, where the drift layer and the first semiconductor layer are doped with impurities of a same property, and a doping concentration of the first semiconductor layer is between the doping concentration of the drift layer and the doping concentration of the first electrode layer.

In this implementation, the first semiconductor layer may be used as a field cut-off layer to prevent an electric field in the drift layer from extending to the first electrode layer, and may avoid electric leakage of the diode at the first electrode layer, thereby reducing a risk of breakdown of the diode, and improving reliability of the diode.

In a possible implementation, the first region and the second region are doped with an acceptor impurity, and the first electrode layer and the drift layer are doped with a donor impurity; or the first region and the second region are doped with a donor impurity, and the first electrode layer and the drift layer are doped with an acceptor impurity.

In this implementation, regardless of a property of the impurity doped in the first region and the second region, a structure of the diode provided in this application may disperse a current in the second region, thereby improving reliability of the diode. In other words, the structure of the diode has high universality.

In a possible implementation, at least one field limiting ring is disposed at an upper portion of the terminal region.

In this implementation, a field limiting ring is disposed at an upper portion of the terminal region, and the field limiting ring may be embedded into the terminal region from an upper surface of the terminal region. The field limiting ring may be used as a voltage divider of the second electrode layer, so that a breakdown voltage of the second electrode layer may be increased, thereby improving reliability of the diode. Specifically, when a voltage V1 applied to the second electrode layer is lower than a breakdown voltage Vb of the second electrode layer, the electric field may be extended to the field limiting ring. When the voltage V1 applied to the second electrode layer increases, the increased voltage is borne by the field limiting ring. In this way, the breakdown voltage of the second electrode layer may be increased.

In a possible implementation, a metal field plate is disposed above the field limiting ring.

In this implementation, a metal field plate may increase a breakdown voltage of the second electrode layer. In particular, when silicon dioxide is used as a protective layer on the upper surface of the terminal region, because a movable charge and trap exist in a silicon dioxide layer, a positive charge exists on an interface between the silicon dioxide layer and the terminal region, and another charge may also be attached to a surface of the silicon dioxide layer. These charges cause concentration and instability of an electric field on a surface of the terminal region, thereby affecting a withstand voltage characteristic of the second electrode layer. The metal field plate may disperse the electric field of on a surface of the terminal region, so as to improve a withstand voltage level of the second electrode layer. In other words, the metal field plate may increase the breakdown voltage of the second electrode layer.

In a possible implementation, the diode further includes a resistive field plate surrounding the metal field plate.

In this implementation, the electric field of on a surface of the terminal region may be dispersed by a resistive field plate, so that the breakdown voltage of the second electrode layer may be increased.

In a possible implementation, the diode further includes a cut-off ring surrounding an upper portion of the terminal region.

The cut-off ring is a semiconductor layer doped with an impurity surrounding the upper portion of the terminal region, a property or type of the impurity doped into the cut-off ring is the same as that of the impurity doped into the terminal region, and a doping concentration of the cut-off ring is greater than a doping concentration of the terminal region. The cut-off ring is configured to cut off an electric field in the terminal region that passes through a side wall of the terminal region, so as to avoid electric leakage of the diode at a side wall of the terminal region, thereby reducing a risk of breakdown of the diode, and improving reliability of the diode.

In this implementation, the diode has the cut-off ring, and may be configured to cut off the electric field in the terminal region that passes through the side wall of the terminal region, so as to avoid the electric leakage of the diode at the side wall of the terminal region, thereby reducing the risk of breakdown of the diode, and improving reliability of the diode.

According to a second aspect, a power circuit is provided, including the diode provided in the first aspect and an insulated gate bipolar transistor.

The diode and the power circuit provided in the embodiments of this application may reduce a risk that the diode is burned, while ensuring the conduction characteristic of the diode, and have high reliability.

### BRIEF DESCRIPTION OF DRAWINGS

FIG. 1 is a schematic structural diagram of a prior art diode;
FIG. 2 is a schematic structural diagram of a power circuit;
FIG. 3 is a schematic structural diagram of a further prior art diode;
FIG. 4A is a schematic structural diagram of a diode according to an embodiment of this application;
FIG. 4B is a top view of the diode shown in FIG. 4A;
FIG. 5 is a schematic structural diagram of a diode according to an embodiment of this application;
FIG. 6A is a schematic structural diagram of a diode according to an embodiment of this application;
FIG. 6B is a top view of the diode shown in FIG. 6A; and
FIG. 7 is a schematic structural diagram of a diode according to an embodiment of this application.

### DESCRIPTION OF EMBODIMENTS

The following describes technical solutions of the embodiments in this application with reference to accompanying drawings. It is clear that the described embodiments are merely some but not all of embodiments of this application.

A diode is widely used, is an important power element, and may be applied to a plurality of power circuits, such as an inverter circuit, a rectifier circuit, and a freewheeling circuit.

FIG. 2 shows a power circuit that can convert a direct current into an alternating current. The power circuit may be a three-phase inverter circuit that includes three bridge arms. The three bridge arms are configured to generate a U phase, a V phase, and a W phase. Two switching elements may be disposed on each bridge arm in series. By controlling connection and disconnection of the switching elements on different bridge arms, a direct current may be converted into an alternating current, so that an alternating current motor may be driven. The switching element on the bridge arm generally includes a diode and an IGBT. In other words, the diode is one of critical components of the power circuit.

It may be understood that FIG. 2 is merely used as an example to describe a purpose of the diode, but does limit the purpose of the diode. There are other purposes of the diode, which are not enumerated herein.

When the diode changes from an on state to an off state, under an action of a reverse voltage, a large quantity of carriers stored in a terminal region are extracted through an electrode layer. A hole is extracted through a P-type anode layer, and an electron is extracted through an N-type cathode layer. Due to factors such as diffusion of a P-type impurity, an edge of the P-type anode layer is curve-shaped. The curved edge is closer to the terminal region, and therefore a large quantity of holes in the terminal region are extracted through the curved edge, resulting in high current density and a large amount of heat. In addition, curvature effect of the curved edge causes an electric field to concentrate, thereby generating an avalanche, so that currents of the curved edge are further concentrated, thereby generating more heat. The heat may burn the diode.

The reverse voltage refers to a voltage at which the diode is in an off state. In other words, the reverse voltage is applied to the diode, and the diode enters the off state. A forward voltage is opposite to the reverse voltage. When the forward voltage is applied to the diode, the diode enters an on state. A carrier is a particle with a charge that may move freely. In the field of semiconductors, the carrier generally refers to an electron and a hole. In other words, the electron and the hole may be collectively referred to as a carrier, the electron is one type of the carrier, and the hole is another type of the carrier. The hole is also referred to as an electron hole (electron hole), and is a vacancy left on a covalent bond after one electron is lost on the covalent bond.

FIG. 3 shows a solution. In this solution, an outer region of a P-type anode layer does not cover a metal electrode. When a diode is on, an electric potential of the outer region is lower than an electric potential of a central region, efficiency of injecting carriers into a terminal region through the outer region is low, and fewer carriers are injected. When the diode is off, a small quantity of carriers are extracted through the outer region, so as to avoid a risk of burning caused by current concentration in the outer region. In this manner, if a width of the outer region covering the metal electrode is small, effect of suppressing current concentration in the outer region is not obvious. A risk of burning caused by current concentration still exists. If the width of an outer region covering the metal electrode is large, an area of the central region covering the metal electrode is small, so that a conduction characteristic of the diode is affected.

Referring to FIG. 4A, an embodiment of this application provides a diode, including an electrode layer 200 and a drift layer 300 disposed on one side of the electrode layer 200. For ease of description, a direction of a side of the electrode layer 200 facing the drift layer 300 may be referred to as an upper direction of the electrode layer 200, that is, the drift layer 300 is located above the electrode layer 200. Correspondingly, a direction of a side of the electrode layer 200 away from the drift layer 300 may be referred to as a lower direction of the electrode layer 200. In addition, in the following description, for layers or components located above the electrode layer 200, an upper direction of the layers or components refers to a direction away from the electrode layer 200, and a lower direction refers to a direction close to the electrode layer 200.

As shown in FIG. 4A, the drift layer 300 includes an active region 310 and a terminal region 320. The terminal region 320 surrounds the active region 310. In other words, the active region 310 is a central region of the drift layer 300, and the terminal region 320 is an edge region of the active region 310.

An electrode layer 100 is disposed at an upper portion of the active region 310. The electrode layer 100 may be divided into a region 110 and a region 120. The region 120 surrounds the region 110, or the region 120 is located around the region 110. In other words, the region 110 is a central region of the electrode layer 100, and the region 120 is an edge region of the electrode layer 100. The upper portion of the active region 310 refers to an end of the active region 310 away from the electrode layer 200.

As shown in FIG. 4A, an insulation trench 130 is disposed between the region 110 and the region 120. In other words, the region 110 and the region 120 are separated by an insulation trench 130. The insulation trench 130 is insulated. In an example, a depth of the insulation trench 130 is from 4 um to 7 um.

As shown in FIG. 4A, the insulation trench 130 may include an insulation layer 131. The insulation layer 131 forms a periphery of the insulation trench 130, so that the insulation trench 130 is insulated. In this way, an electric field of the region 110 may be prevented from extending into the region 120. In some embodiments, the insulation layer 131 may be made of silicon dioxide.

A conductor 140 is disposed at an upper portion of the region 110. The conductor 140 is in contact with the region 110, so that the region 110 may be connected to a power supply A1 (not shown) through the conductor. A conductor 160 is disposed at an upper portion of the region 120. The conductor 160 is in contact with the region 120. There is a resistor 150 between the conductor 140 and the conductor 160. In other words, the conductor 140 and the conductor 160 are connected by the resistor 150. The conductor 160 is not directly connected to the power supply A1, but is connected to the power supply A1 through the resistor 150 and the conductor 140. Therefore, the region 120 is connected to the power supply A1 through the conductor 160, the resistor 150, and the conductor 140 sequentially.

When the diode is on, the resistor 150 enables an electric potential of the region 120 to be lower than an electric potential of the region 110, that is, the resistor 150 may reduce the electric potential of the region 120. In this way, efficiency of injecting carriers into the terminal region 320 by the region 120 is low. Therefore, when the diode is off, fewer carriers flow through the region 120, thereby suppressing current concentration in the region 120, and suppressing a risk of burning caused by current concentration in the region 120. In addition, when the diode is off, the carriers flow through the resistor 150 through the region 120, and an electric potential of the resistor 150 is increased, thereby reducing an electric potential difference between the region 120 and the electrode layer 200, further reducing the carriers that flow through the region 120, and reducing a risk of burning caused by current concentration in the region 120. In addition, a capability of the resistor 150 for blocking a carrier or a resistance value of the resistor 150 may be adjusted by a material or a wiring length of the resistor 150, without occupying an excessive area of the electrode layer 100, so that an area of the region 110 may be ensured, and impact on a conduction characteristic of the diode is small.

In this embodiment of this application, the resistor 150 is an object whose resistivity is between a conductor and an insulator. The resistor has a large resistivity, which may block a current from passing through, but not completely block the current from passing through. In some embodiments, the resistor 150 may be specifically polycrystalline silicon. In this embodiment of this application, a conductor (for example, the conductor 140 or the conductor 160) is an object that has an extremely low resistivity and is easy to conduct a current. In some embodiments, the conductor may be a metal or a metal electrode, such as a tungsten electrode or an aluminum electrode. In other embodiments, the conductor may be another object having a good conductivity. A material of the conductor is not specifically limited in this embodiment of this application.

In addition, in the embodiments of this application, "contact" may be understood as "adjacent", and generally means that two objects in a block shape or a sheet shape are adjacent to each other, or one of the two objects is located on a surface of the other object. In addition, in this embodiment of this application, "connection" may mean direct contact of two objects. The "connection" may also mean that two objects are connected by a third object, that is, one side or one end of the third object is in contact with one of the two objects, and the other side or the other end of the third object is in contact with the other one of the two objects.

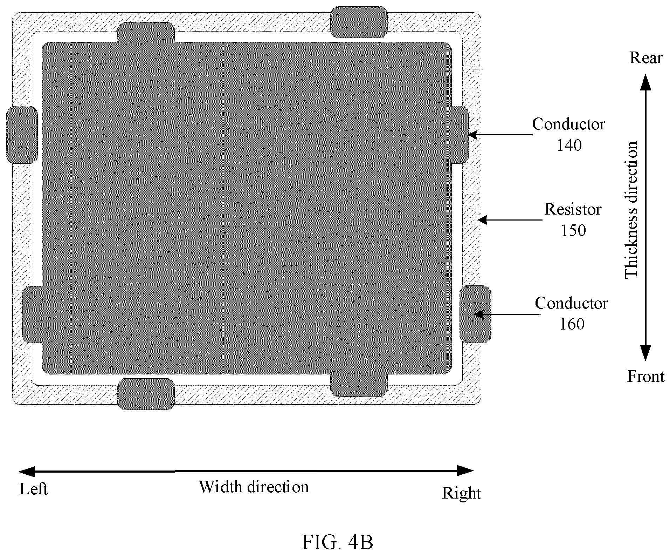

In some embodiments, referring to FIG. 4B, a part of the conductor 140 that is in contact with the resistor 150 is staggered with the conductor 160 in a thickness direction, and has a preset distance. Accordingly, the resistor 150 may have a length in the thickness direction. Therefore, in a case in which a small area of the electrode layer 100 is occupied, a wiring length of the resistor 150 connecting the conductor 140 and the conductor 160 may be increased, and a capability of the resistor 150 for blocking a carrier or a resistance value of the resistor 150 is increased.

The vertical direction shown in FIG. 4A may correspond to a y-axis direction in a three-dimensional coordinate system, a width direction corresponds to an x-axis direction in the three-dimensional coordinate system, and the thickness direction shown in FIG. 4B corresponds to a z-axis direction in the three-dimensional coordinate system.

The conductor 140 may be used as an electrode B1 of the diode. A conductor 210 located below the electrode layer 200 may be used as an electrode B2 of the diode. The electrode B1 may be an anode (anode) of the diode, and the electrode B2 may be a cathode (cathode) of the diode. Alternatively, the electrode B1 may be a cathode (cathode) of the diode, and the electrode B2 may be an anode (anode) of the diode. That is, the electrode B1 may be an anode or a cathode; and the electrode B2 may be an anode or a cathode. When the electrode B1 is an anode, the electrode B2 is a cathode; and when the electrode B2 is an anode, the electrode B1 is a cathode.

In some embodiments, the electrode B1 is an anode, and the electrode B2 is a cathode. In this case, the electrode layer 100 may be a P (positive) semiconductor, and is used as a P-type anode region. The P-type semiconductor refers to a semiconductor doped with a P-type impurity. The P-type impurity may also be referred to as an acceptor impurity (acceptor impurity), and is an impurity that may provide a hole for a semiconductor material, for example, a group III element such as B, Al, Ga, and In.

The electrode layer 200 may be an N (negative) semiconductor, and is used as an N-type cathode region. The N-type semiconductor refers to a semiconductor doped with an N-type impurity. The N-type impurity may also be referred to as a donor impurity (donor impurity), and is an impurity that may provide an electron for a semiconductor material, for example, a group V element such as phosphorus, arsenic, and antimony.

In some embodiments, the electrode B2 is an anode, and the electrode B1 is a cathode. In this case, the electrode layer 100 is an N-type semiconductor, and is used as an N-type cathode region. The electrode layer 200 is a P-type semiconductor layer, and is used as a P-type anode region.

Properties of an impurity doped into the drift layer 300 and an impurity doped into the electrode layer 200 are the same. That is, when the electrode layer 200 is a P-type semiconductor, the drift layer 300 is also a P-type semiconductor. That is, when the electrode layer 200 is an N-type semiconductor, the drift layer 300 is also an N-type semiconductor. A doping concentration of the impurity in the drift layer 300 is lower than a doping concentration of the impurity in the electrode layer 200. In other words, the drift layer 300 is a lightly doped semiconductor, and the electrode layer 200 is a heavily doped semiconductor. Light doping means that less impurities are doped into a semiconductor. Heavy doping, corresponding to the light doping, means that a large quantity of impurities is doped into a semiconductor. In other words, doping may be classified into light doping and heavy doping based on a quantity of impurities to be doped.

In some embodiments, there is a semiconductor layer 400 between the drift layer 300 and the electrode layer 200. Properties of an impurity doped into the semiconductor layer 400 and an impurity doped into the electrode layer 200 are the same. That is, when the electrode layer 200 is a P-type semiconductor, the semiconductor layer 400 is also a P-type semiconductor. That is, when the electrode layer 200 is an N-type semiconductor, the semiconductor layer 400 is also an N-type semiconductor. A doping concentration of the impurity in the semiconductor layer 400 is lower than the doping concentration in the electrode layer 200, but is higher than the doping concentration in the drift layer 300. That is, the doping concentration of impurities in the electrode layer 200, the doping concentration of impurities in the semiconductor layer 400, and the doping concentration of impurities in the drift layer 300 decreases sequentially.

The semiconductor layer 400 may also be referred to as a field stop layer, and may prevent an electric field in the drift layer 300 from extending to the electrode layer 200, thereby avoiding electric leakage of the diode at the electrode layer 200, reducing a risk of breakdown of the diode, and improving reliability of the diode.

Returning to FIG. 4A, in some embodiments, at least one field limiting ring (FLR) 321 is disposed at an upper portion of the terminal region 320. The at least one field limiting ring 321 is embedded into the terminal region 320 from an upper surface of the terminal region. The field limiting ring 321 is also used as a field limiting ring junction of the electrode layer 100. Correspondingly, the electrode layer 100 is used as a main junction of the field limiting ring 321. Properties of an impurity doped into the field limiting ring 321 and an impurity doped into the electrode layer 100 are the same. That is, when the electrode layer 100 is a P-type semiconductor, the field limiting ring 321 is also a P-type semiconductor. That is, when the electrode layer 100 is an N-type semiconductor, the field limiting ring 321 is also an N-type semiconductor. The field limiting ring 321 may increase a breakdown voltage of the electrode layer 100. Specifically, when a reverse voltage V1 applied to the electrode layer 100 is lower than a breakdown voltage Vb of the electrode layer 100, the electric field may be extended to the field limiting ring. When the reverse voltage V1 applied to the electrode layer 100 increases, the increased voltage is borne by the field limiting ring 321. In this way, the field limiting ring 321 is equivalent to a voltage divider of the electrode layer 100, and may increase the breakdown voltage of the electrode layer 100.

Still referring to FIG. 4A, in some embodiments, a field plate (FP) 323 is disposed above the field limiting ring 321. For example, a field plate 323 may be a metal field plate (MFP). The field plate 323 may increase the breakdown voltage of the electrode layer 100. Specifically, silicon dioxide is used as a protective layer on an upper surface of the terminal region 320, that is, the upper surface is covered with a silicon dioxide layer. Because there are movable charges and traps in the silicon dioxide layer, there is a positive charge on an interface between the silicon dioxide layer and the terminal region 320, and another charge may also be attached to a surface of the silicon dioxide layer. These charges cause concentration and instability of an electric field on a surface of the terminal region 320, thereby affecting a withstand voltage characteristic of the electrode layer 100. The field plate 323 may disperse an electric field of a surface of the terminal region 320, thereby improving a withstand voltage level of the electrode layer 100, that is, increasing the breakdown voltage of the electrode layer 100.

On the surface of the terminal region 320, a dielectric layer 325 is covered between adjacent field plates 323. The dielectric layer 325 may also be referred to as an insulation layer, and may be used as a protective layer on the surface of the terminal region 320. In some embodiments, the dielectric layer 325 may be made of silicon dioxide.

Still referring to FIG. 4A, in some embodiments, the field plate 323 is surrounded by a field plate 324, that is, the field plate 324 is disposed around the field plate 323. For example, the field plate 324 may be a resistive field plate (RFP). For example, the field plate 324 may be made of polycrystalline silicon. The field plate 324 may also disperse the electric field on the surface of the terminal region 320, thereby increasing the breakdown voltage of the electrode layer 100.

In some embodiments, a cut-off ring 322 is disposed at an outer edge of an upper portion of the terminal region 320. That is, the cut-off ring 322 surrounds the upper portion of the terminal region 320. Properties of an impurity doped into the cut-off ring 322 and an impurity doped into the terminal region 320 are the same. That is, when the terminal region 320 is an N-type semiconductor, the cut-off ring 322 is an N-type semiconductor. That is, when the terminal region 320 is a P-type semiconductor, the cut-off ring 322 is a P-type semiconductor. In addition, a doping concentration of the cut-off ring 322 is greater than a doping concentration of the terminal region 320. The cut-off ring 322 may increase a breakdown voltage of the terminal region 320. Specifically, the cut-off ring 322 may cut off an electric field in the terminal region 320 that passes through a side wall of the terminal region 320, so as to avoid leakage of the diode at the side wall of the terminal region 320, thereby reducing a risk of breakdown of the diode, and improving reliability of the diode.

The structure of the diode is described above with reference to FIG. 4A and FIG. 4B. Next, a solution for preparing the semiconductor device shown in FIG. 4A is described by using an example.

A silicon wafer (for example, float-zone silicon (float-zone silicon)) having a thickness and a certain doping concentration may be selected as the drift layer 300.

An upper surface structure of the drift layer 300 may be prepared first. Specifically, the field limiting ring 321, the cut-off ring 322, and the electrode layer 100 may be prepared by an ion implantation doping process and a push knot process. Then, an oxide layer (for example, a silicon dioxide layer) is deposited on an upper surface of the drift layer 300 to be used as a mask. Etching is performed in a region corresponding to the insulation trench 130 to obtain a U-shaped groove, and an oxide layer on a surface of the region 120 is etched off. Then, a U-shaped insulation layer is prepared in a U-shaped groove in a thermal growth manner, and an insulation layer is prepared on a surface of the region 120, so as to obtain an insulation layer 131. A resistor 150 (for example, polycrystalline silicon) is then deposited on the insulation layer 131. Afterwards, an insulation layer is deposited on the resistor 150. The oxide layer corresponding to the conductor 140 in the region 110 and the oxide layer corresponding to the conductor 160 in the region 120 are etched off, and the oxide layer or the insulation layer corresponding to the conductor in the resistor 150 is etched off. Finally, the conductor 140 and the conductor 160 are deposited in a corresponding region. The "corresponding conductor" refers to a position that needs to or is to contact the conductor.

In addition, for preparation processes of the field plate 323, the field plate 324, and the dielectric layer 325, reference may be made to the description in the prior art. Details are not described herein again.

In this way, the upper surface structure of the drift layer 300 may be prepared.

Then, the drift layer 300 may be flipped over to prepare a lower surface structure of the drift layer 300. Specifically, impurities may be injected into a lower end of the drift layer 300 by an ion implantation doping process and a push knot, to prepare the semiconductor layer 400 and the electrode layer 200. Energy of an ion beam used to prepare the semiconductor layer 400 is higher than that of an ion beam used to prepare the electrode layer 200. Then, the conductor 210 may be prepared on a side that is of the electrode layer 200 and that is away from the drift layer 300.

Therefore, the diode shown in FIG. 4A may be prepared.

In addition, the foregoing describes only an example of a preparation process of the diode shown in FIG. 4A, and does not constitute a limitation. In another embodiment, the diode shown in FIG. 4A may be prepared by using another process. Details are not described herein again.

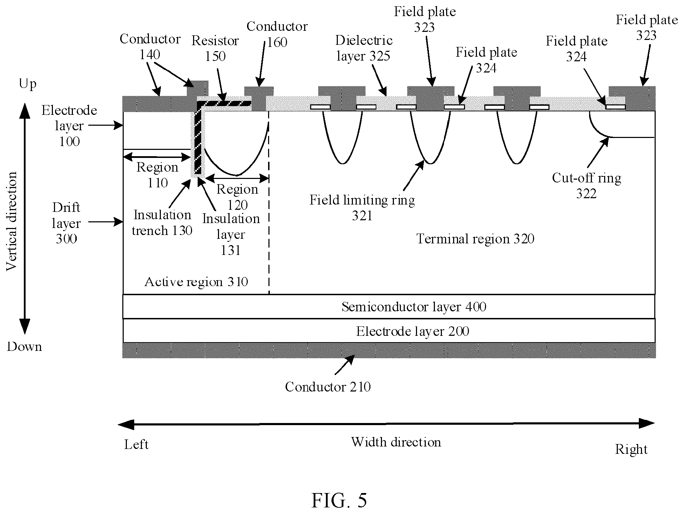

Referring to FIG. 5, an embodiment of this application further provides a diode. The diode includes an electrode layer 200, and a drift layer 300 disposed on one side of the electrode layer 200. The drift layer 300 includes an active region 310 and a terminal region 320. The terminal region 320 surrounds the active region 310. An electrode layer 100 is disposed at an upper portion of the active region 310. The electrode layer 100 may be divided into a region 110 and a region 120. The region 120 surrounds the region 110. An insulation trench 130 is disposed between the region 110 and the region 120.

A conductor 140 is disposed at an upper portion of the region 110. The conductor 140 is in contact with the region 110, so that the region 110 may be connected to a power supply A1 through the conductor. A conductor 160 is disposed at an upper portion of the region 120. The conductor 160 is in contact with the region 110. There is a resistor 150 between the conductor 140 and the conductor 160. The conductor 160 is not directly connected to the power supply A1, but is connected to the power supply A1 through the resistor 150 and the conductor 140. Therefore, the region 120 is connected to the power supply A1 through the conductor 160, the resistor 150, and the conductor 140 sequentially.

Still referring to FIG. 5, in some embodiments, a semiconductor layer 400 is disposed between the electrode layer 200 and the drift layer 300.

In some embodiments, at least one field limiting ring 321 is disposed at an upper portion of the terminal region 320. A field plate 323 is disposed above the field limiting ring 321. On the surface of the terminal region 320, a dielectric layer 325 is covered between adjacent field plates 323. The field plate 323 is surrounded by a field plate 324. A cut-off ring 322 is disposed at an outer edge of an upper portion of the terminal region 320.

For specific implementations and functions of the components in the diode shown in FIG. 5, reference may be made to the foregoing descriptions of the diode shown in FIG. 4A.

Different from the diode shown in FIG. 4A, in the diode shown in FIG. 5, a depth by which the region 120 extends into the active region 310 is greater than a depth by which the region 110 extends into the active region 310. Referring to FIG. 5, a direction of an extension depth is downward in a vertical direction. The extension depth specifically refers to a degree of downward depth along the vertical direction. An extension depth of the region in the active region 310 may also be understood as a degree to which a lower end of the region is close to the electrode layer 200. As an extension depth of the region in the active region 310 is larger, a lower end of the region is closer to the electrode layer 200. The extension depth may be referred to as a junction depth for short. The lower end of the region is an end of the region closest to the electrode layer 200. In the diode shown in FIG. 5, a junction depth of the region 120 is large, and an interface between the region 120 and the drift layer 300 is large, so that an electric field of the interface may be dispersed, thereby suppressing generation of heat, reducing a risk that the diode is burned, and improving reliability of the diode.

In addition, the diode shown in FIG. 5 may be prepared with reference to a preparation process of the diode shown in FIG. 4A. A difference is that when the diode shown in FIG. 5 is prepared, duration of push knot processing performed on the region 120 is greater than duration of push knot processing performed on the region 110, so that a junction depth of the region 120 is greater than a junction depth of the region 110.

Therefore, the diode shown in FIG. 5 may be prepared.

In addition, the foregoing describes only an example of a preparation process of the diode shown in FIG. 5, and does not constitute a limitation. In another embodiment, the diode shown in FIG. 5 may be prepared by using another process. Details are not described herein again.

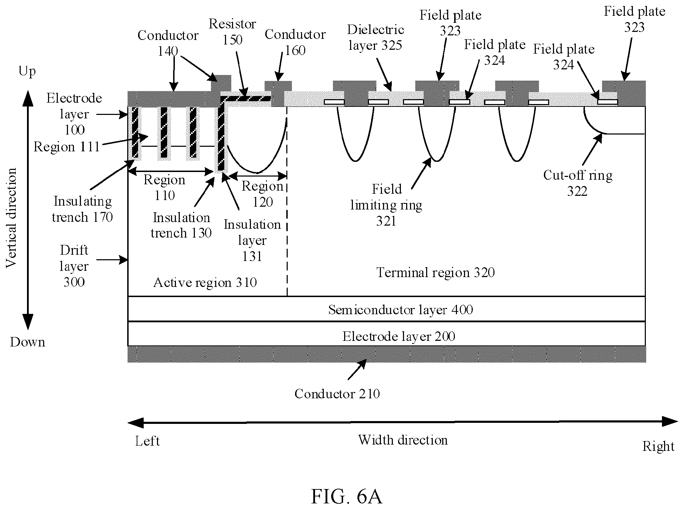

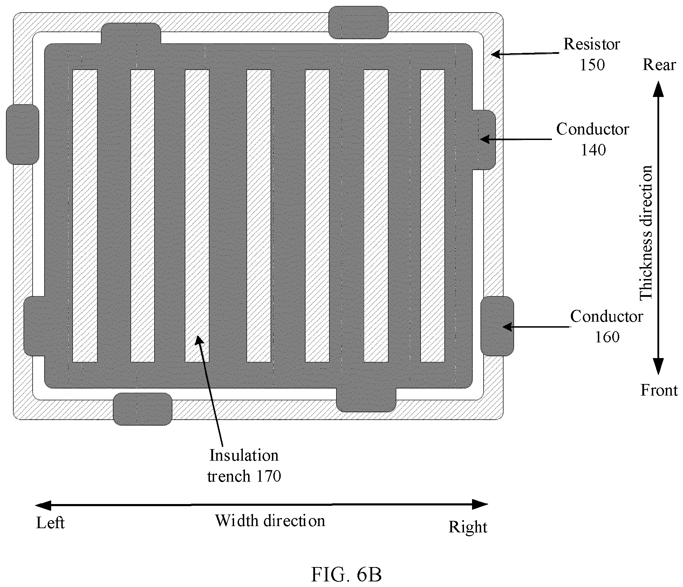

Referring to FIG. 6A and FIG. 6B, an embodiment of this application further provides a diode. The diode includes an electrode layer 200, and a drift layer 300 disposed on one side of the electrode layer 200. The drift layer 300 includes an active region 310 and a terminal region 320. The terminal region 320 surrounds the active region 310. An electrode layer 100 is disposed at an upper portion of the active region 310. The electrode layer 100 may be divided into a region 110 and a region 120. The region 120 surrounds the region 110. An insulation trench 130 is disposed between the region 110 and the region 120. For example, a depth by which the region 120 extends into the active region 310 is greater than a depth by which the region 110 extends into the active region 310.

A conductor 140 is disposed at an upper portion of the region 110. The conductor 140 is in contact with the region 110, so that the region 110 may be connected to a power supply A1 through the conductor. A conductor 160 is disposed at an upper portion of the region 120. The conductor 160 is in contact with the region 110. There is a resistor 150 between the conductor 140 and the conductor 160. The conductor 160 is not directly connected to the power supply A1, but is connected to the power supply A1 through the resistor 150 and the conductor 140. Therefore, the region 120 is connected to the power supply A1 through the conductor 160, the resistor 150, and the conductor 140 sequentially.

Still referring to FIG. 6A, in some embodiments, a semiconductor layer 400 is disposed between the electrode layer 200 and the drift layer 300.

In some embodiments, at least one field limiting ring 321 is disposed at an upper portion of the terminal region 320. A field plate 323 is disposed above the field limiting ring 321. On the surface of the terminal region 320, a dielectric layer 325 is covered between adjacent field plates 323. The field plate 323 is surrounded by a field plate 324. A cut-off ring 322 is disposed at an outer edge of an upper portion of the terminal region 320.

For specific implementations and functions of the components in the diode shown in FIG. 6A, reference may be made to the foregoing descriptions of the diode shown in FIG. 4A or FIG. 5.

Different from the diode shown in FIG. 4A, in the diode shown in FIG. 6A, the region 110 includes a plurality of regions 111, and two adjacent regions 111 in the plurality of regions 111 are separated by an insulation trench 170. In addition, as shown in FIG. 6A, a depth by which the insulation trench 170 extends into the active region 310 is greater than a depth by which the region 111 extends into the active region 310. In this way, when the diode is in an on state, the insulation trench 170 may block or slow down migration of carriers in the region 111 to the terminal region 320, thereby reducing a quantity of carriers in the terminal region 320. Therefore, when the diode is off, a quantity of carriers that are extracted through the region 120 is also small, thereby further reducing current density of the region 120, suppressing heat generation, reducing a risk that the diode is burned, and improving reliability of the diode.

In addition, the diode shown in FIG. 6A may be prepared with reference to a preparation process of the diode shown in FIG. 4A. A difference is that when the diode shown in FIG. 6A is prepared, the insulation trench 170 is also prepared while the insulation trench 130 is prepared, so as to divide the region 110 into a plurality of regions 111. A preparation process of the insulation trench 170 is the same as that of the insulation trench 130. Details are not described herein again. In some embodiments, when the diode shown in FIG. 6A is prepared, the duration of the push-junction processing of the region 120 is greater than the duration of the push-junction processing of the region 110, so that the junction depth of the region 120 is greater than the junction depth of the region 110.

Therefore, the diode shown in FIG. 6A may be prepared.

In addition, the foregoing describes only an example of a preparation process of the diode shown in FIG. 6A, and does not constitute a limitation. In another embodiment, the diode shown in FIG. 6A may be prepared by using another process. Details are not described herein again.

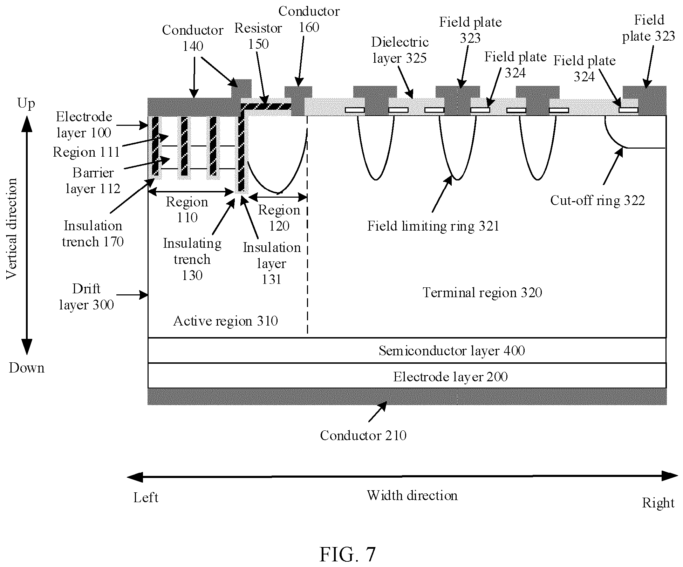

Referring to FIG. 7, an embodiment of this application further provides a diode. The diode includes an electrode layer 200, and a drift layer 300 disposed on one side of the electrode layer 200. The drift layer 300 includes an active region 310 and a terminal region 320. The terminal region 320 surrounds the active region 310. An electrode layer 100 is disposed at an upper portion of the active region 310. The electrode layer 100 may be divided into a region 110 and a region 120. The region 120 surrounds the region 110. An insulation trench 130 is disposed between the region 110 and the region 120. For example, a depth by which the region 120 extends into the active region 310 is greater than a depth by which the region 110 extends into the active region 310.

A conductor 140 is disposed at an upper portion of the region 110. The conductor 140 is in contact with the region 110, so that the region 110 may be connected to a power supply A1 through the conductor. A conductor 160 is disposed at an upper portion of the region 120. The conductor 160 is in contact with the region 110. There is a resistor 150 between the conductor 140 and the conductor 160. The conductor 160 is not directly connected to the power supply A1, but is connected to the power supply A1 through the resistor 150 and the conductor 140. Therefore, the region 120 is connected to the power supply A1 through the conductor 160, the resistor 150, and the conductor 140 sequentially.

Still referring to FIG. 7, in some embodiments, a semiconductor layer 400 is disposed between the electrode layer 200 and the drift layer 300.

In some embodiments, at least one field limiting ring 321 is disposed at an upper portion of the terminal region 320. A field plate 323 is disposed above the field limiting ring 321. On the surface of the terminal region 320, a dielectric layer 325 is covered between adjacent field plates 323. The field plate 323 is surrounded by a field plate 324. A cut-off ring 322 is disposed at an outer edge of an upper portion of the terminal region 320.

For specific implementations and functions of the components in the diode shown in FIG. 7, reference may be made to the foregoing descriptions of the diode shown in FIG. 4A, FIG. 5, or FIG. 6A.

Different from the diode shown in FIG. 4A, in the diode shown in FIG. 7, a barrier layer 112 is disposed below the region 110, that is, the barrier layer 112 is disposed between the region 110 and the active region 310. Properties of an impurity doped into the barrier layer 112 and an impurity doped into the region 110 are different. Specifically, when the region 110 is doped with a P-type impurity, the barrier layer 112 is doped with an N-type impurity. When the region 110 is doped with an N-type impurity, the barrier layer 112 is doped with a P-type impurity. A property of the impurity doped into the barrier layer 112 is different from a property of the impurity doped into the region 110. In other words, a property of the impurity doped into the barrier layer 112 is the same as a property of the impurity doped into the drift layer 300. Compared with a doping concentration of the drift layer 300, a doping concentration of the barrier layer 112 is higher.

In some embodiments, as shown in FIG. 7, the region 110 includes a plurality of regions 111, and two adjacent regions 111 in the plurality of regions 111 are separated by an insulation trench 170. In addition, a barrier layer 112 is disposed below the region 111.

When the diode is in an on state, the barrier layer 112 may slow down migration of carrier in the region 111 or the region 110 to the active region 310, thereby reducing carriers diffused to the terminal region 320, and reducing a quantity of carriers in the terminal region 320. Therefore, when the diode is off, a quantity of carriers that are extracted through the region 120 is also small, thereby further reducing current density of the region 120, suppressing heat generation, reducing a risk that the diode is burned, and improving reliability of the diode.

In addition, when the diode shown in FIG. 7 is prepared, when an upper surface structure of the drift layer 300 is prepared, the barrier layer 112 may be prepared at a corresponding position of the drift layer 300 first. For example, the barrier layer 112 is prepared by an ion implantation doping process. Then, a field limiting ring 321, a cut-off ring 322, an electrode layer 100, and the like are prepared. For details, reference may be made to the foregoing descriptions of the diode preparation process shown in FIG. 4A.

In some embodiments, when the diode shown in FIG. 7 is prepared, the insulation trench 170 is also prepared while the insulation trench 130 is being prepared, so as to divide the region 110 into a plurality of regions 111.

In some embodiments, when the diode shown in FIG. 7 is prepared, the duration of the push knot processing of the region 120 is greater than the duration of the push knot processing of the region 110, so that the junction depth of the region 120 is greater than the junction depth of the region 110.

The insulation trench 130 may be prepared first. Then, by the ion implantation doping process, an impurity C1 is injected into a region in which the barrier layer 112 is located, to prepare the barrier layer 112, and an impurity C2 is injected into the region 120. Then, a region above the barrier layer 112 is etched off, and the region 110 is deposited, to prepare the region 110. Alternatively, the insulation trench 130 and the insulation trench 170 may be prepared first. Then, the impurity C1 is injected into the region in which the barrier layer 112 is located by the ion implantation doping process, to prepare the barrier layer 112, and the impurity C2 is injected into the region 120. Then, the region on the barrier layer 112 is etched off, and the region 111 is deposited, to prepare the region 111. Properties of the impurity C1 and the impurity C2 are different.

Then, in the insulation trench 130 and the insulation trench 170 and on the upper surfaces of the region 110 and the region 120, an insulator is deposited in an epitaxial growth manner. Afterwards, the insulator is etched, and a resistor is deposited in the etched insulator in an epitaxial growth manner, so as to prepare an insulation layer 131 and a resistor 150. Next, the insulator on the upper surface of the region 110 is etched off, and then the conductor 140 is prepared.

For a preparation process of another component in the diode shown in FIG. 7, reference may be made to the foregoing descriptions of the preparation process of the diode shown in FIG. 4A. Details are not described herein again.

Therefore, the diode shown in FIG. 7 may be prepared.

In addition, the foregoing describes only an example of a preparation process of the diode shown in FIG. 7, and does not constitute a limitation. In another embodiment, the diode shown in FIG. 7 may be prepared by using another process. Details are not described herein again.

In the description of the embodiments of this application, the described specific features, structures, materials, or characteristics may be combined in a suitable manner in any one or more of the embodiments or examples.

It may be understood that in the descriptions of the embodiments of this application, words such as "exemplary", "example", or "for example" are used to represent giving an example, an illustration, or a description. Any embodiment or design scheme described by "exemplary", "example" or "for example" in embodiments of this application should not be explained as being more preferred or having more advantages than another embodiment or design scheme. To be precise, the words such as "exemplary", "example", or "for example" are intended to present a related concept in a specific manner.

In the descriptions of the embodiments of this application, the term "and/or" describes only an association relationship for describing associated objects and represents that three relationships may exist. For example, A and/or B may represent the following three cases: only A exists, only B exists, and both A and B exist. In addition, unless otherwise specified, the term "a plurality of" means two or more. For example, a plurality of systems refer to two or more systems, and a plurality of terminals refer to two or more terminals.

In addition, the terms "first" and "second" are merely intended for a purpose of description, and shall not be understood as an indication or implication of relative importance or implicit indication of serial numbers of indicated technical features. Therefore, a feature limited by "first" or "second" may explicitly or implicitly include one or more features. The terms "include", "comprise", "have" and their variants mean "including but not limited to" unless specifically emphasized otherwise.

It can be understood that, the foregoing embodiments are merely intended for describing the technical solutions of this application, but for limiting this application. Although this application is described in detail with reference to the foregoing embodiments, a person of ordinary skill in the art should understand that modifications to the technical solutions recorded in the foregoing embodiments or equivalent replacements to some technical features thereof may still be made, without departing from the scope of the technical solutions of embodiments of this application.

The foregoing descriptions are merely specific implementations of this application, but are not intended to limit the protection scope of this application. Any variation or replacement readily figured out by a person skilled in the art within the technical scope disclosed in the present invention shall fall within the protection scope of this application. Therefore, the protection scope of this application shall be defined solely by the appended claims.

## Claims

1. A diode, comprising:
a first electrode layer (200);
a drift layer (300) located above the first electrode layer, wherein a doping concentration of the drift layer is less than a doping concentration of the first electrode layer, and the drift layer comprises an active region (310) and a terminal region (320) surrounding the active region;
a first region (110) and a second region (120) surrounding the first region, wherein the first region and the second region are disposed at an upper portion of
the active region and the first region and the second region are separated by and adjoining a first insulation trench (130); and
a first conductor (140) disposed above the first region, a second conductor (160) disposed above the second region, and a first resistor (150) disposed between the first conductor and the second conductor, wherein
the first region is connected to a power supply through the first conductor, and the second region is connected to the power supply through the second conductor, the first resistor, and the first conductor sequentially;
wherein the first region and the second region are doped with acceptor impurities, and the first electrode layer and the drift layer are doped with donor impurities; or the first region and the second region are doped with donor impurities, and the first electrode layer and the drift layer are doped with acceptor impurities.

2. The diode according to claim 1, wherein a depth by which the second region extends into the active region is greater than a depth by which the first region extends into the active region.

3. The diode according to claim 1 or 2, wherein the first region comprises a plurality of third regions (111) above the active region, adjacent third regions in the plurality of third regions are separated by a second insulation trench (170), and a depth by which the second insulation trench extends into the active region is greater than a depth by which the third region extends into the active region.

4. The diode according to any one of claims 1 to 3, wherein a barrier layer (112) is disposed between the first region and
the active region, and the barrier layer is configured to slow down migration of a carrier between the first region and the active region, and wherein the barrier layer and the drift layer are both doped either with acceptor impurities or with donor impurities.

5. The diode according to any one of claims 1 to 4, wherein the first resistor is polycrystalline silicon.

6. The diode according to any one of claims 1 to 5, wherein a first semiconductor layer (400) is disposed between the drift layer and the first electrode layer, the drift layer and the first semiconductor layer are both doped with either acceptor impurities or with donor impurities, and a doping concentration of the first semiconductor layer is between the doping concentration of the drift layer and the doping concentration of the first electrode layer.

7. The diode according to any one of claims 1 to 6, wherein at least one field limiting ring (321) is disposed in the terminal region.

8. The diode according to claim 7, wherein a metal field plate (323) is disposed above the field limiting ring.

9. The diode according to claim 8, wherein the diode further comprises a resistive field plate (324) surrounding the metal field plate.

10. The diode according to any one of claims 1 to 9, wherein the diode further comprises a cut-off ring (322) surrounding the upper portion of the terminal region.

11. A power circuit, comprising the diode according to any one of claims 1 to 10 and an insulated gate bipolar transistor.

## Patentansprüche

1. Diode, umfassend:
eine erste Elektrodenschicht (200);
eine Driftschicht (300), die sich über der ersten Elektrodenschicht befindet, wobei eine Dotierungskonzentration der Driftschicht geringer als eine Dotierungskonzentration der ersten Elektrodenschicht ist und die Driftschicht einen aktiven Bereich (310) und einen Anschlussbereich (320), der den aktiven Bereich umgibt, umfasst;
einen ersten Bereich (110) und einen den zweiten Bereich (120), der den ersten Bereich umgibt, wobei der erste Bereich und der zweite Bereich an einem oberen Abschnitt des aktiven Bereichs angeordnet sind und der erste Bereich und der zweite Bereich durch einen ersten Isolationsgraben (130) getrennt sind und an diesen angrenzen; und
einen ersten Leiter (140), der über dem ersten Bereich angeordnet ist, einen zweiten Leiter (160), der über dem zweiten Bereich angeordnet ist, und einen ersten Widerstand (150), der zwischen dem ersten Leiter und dem zweiten Leiter angeordnet ist, wobei
der erste Bereich über den ersten Leiter mit einer Leistungsversorgung verbunden ist und der zweite Bereich nacheinander über den zweiten Leiter, den ersten Widerstand und den ersten Leiter mit der Leistungsversorgung verbunden ist;
wobei der erste Bereich und der zweite Bereich mit Akzeptor-Verunreinigungen dotiert sind und die erste Elektrodenschicht und die Driftschicht mit Donator-Verunreinigungen dotiert sind; oder der erste Bereich und der zweite Bereich mit Donator-Verunreinigungen dotiert sind und die erste Elektrodenschicht und die Driftschicht mit Akzeptor-Verunreinigungen dotiert sind.

2. Diode nach Anspruch 1, wobei eine Tiefe, um die sich der zweite Bereich in den aktiven Bereich erstreckt, größer als eine Tiefe ist, um die sich der erste Bereich in den aktiven Bereich erstreckt.

3. Diode nach Anspruch 1 oder 2, wobei der erste Bereich eine Vielzahl von dritten Bereichen (111) über dem aktiven Bereich umfasst, benachbarte dritte Bereiche in der Vielzahl von dritten Bereichen durch einen zweiten Isolationsgraben (170) getrennt sind und eine Tiefe, um die sich der zweite Isolationsgraben in den aktiven Bereich erstreckt, größer als eine Tiefe ist, um die sich der dritte Bereich in den aktiven Bereich erstreckt.

4. Diode nach einem der Ansprüche 1 bis 3, wobei eine Barriereschicht (112) zwischen dem ersten Bereich und dem aktiven Bereich angeordnet ist und die Barriereschicht dazu konfiguriert ist, die Migration eines Trägers zwischen dem ersten Bereich und dem aktiven Bereich zu verlangsamen, und wobei die Barriereschicht und die Driftschicht beide entweder mit Akzeptor-Verunreinigungen oder mit Donator-Verunreinigungen dotiert sind.

5. Diode nach einem der Ansprüche 1 bis 4, wobei der erste Widerstand aus polykristallinem Silizium besteht.

6. Diode nach einem der Ansprüche 1 bis 5, wobei eine erste Halbleiterschicht (400) zwischen der Driftschicht und der ersten Elektrodenschicht angeordnet ist, die Driftschicht und die erste Halbleiterschicht beide entweder mit Akzeptor-Verunreinigungen oder mit Donator-Verunreinigungen dotiert sind und eine Dotierungskonzentration der ersten Halbleiterschicht zwischen der Dotierungskonzentration der Driftschicht und der Dotierungskonzentration der ersten Elektrodenschicht liegt.

7. Diode nach einem der Ansprüche 1 bis 6, wobei mindestens ein Feldbegrenzungsring (321) in dem Anschlussbereich angeordnet ist.

8. Diode nach Anspruch 7, wobei eine metallische Feldplatte (323) über dem Feldbegrenzungsring angeordnet ist.

9. Diode nach Anspruch 8, wobei die Diode ferner eine Widerstandsfeldplatte (324) umfasst, welche die metallische Feldplatte umgibt.

10. Diode nach einem der Ansprüche 1 bis 9, wobei die Diode ferner einen Sperrring (322) umfasst, der den oberen Abschnitt des Anschlussbereichs umgibt.

11. Leistungsschaltung, umfassend die Diode nach einem der Ansprüche 1 bis 10 und einen Bipolartransistor mit isolierter Gate-Elektrode.

## Revendications

1. Diode, comprenant :
une première couche d'électrode (200) ;
une couche de dérive (300) située au-dessus de la première couche d'électrode, dans laquelle une concentration de dopage de la couche de dérive est inférieure à une concentration de dopage de la première couche d'électrode, et la couche de dérive comprend une région active (310) et une région terminale (320) entourant la région active ;
une première région (110) et une deuxième région (120) entourant la première région, dans laquelle la première région et la deuxième région sont disposées dans une partie supérieure de la région active et la première région et la deuxième région sont séparées par et adjacentes à une première tranchée d'isolation (130) ; et
un premier conducteur (140) disposé au-dessus de la première région, un second conducteur (160) disposé au-dessus de la deuxième région, et une première résistance (150) disposée entre le premier conducteur et le second conducteur, dans laquelle
la première région est reliée à une alimentation électrique via le premier conducteur, et la deuxième région est reliée à l'alimentation électrique via le second conducteur, la première résistance et le premier conducteur séquentiellement ;
dans laquelle la première région et la deuxième région sont dopées avec des impuretés acceptrices, et la première couche d'électrode et la couche de dérive sont dopées avec des impuretés donneuses ; ou la première région et la deuxième région sont dopées avec des impuretés donneuses, et la première couche d'électrode et la couche de dérive sont dopées avec des impuretés acceptrices.

2. Diode selon la revendication 1, dans laquelle une profondeur par laquelle la deuxième région se prolonge dans la région active est supérieure à une profondeur par laquelle la première région se prolonge dans la région active.

3. Diode selon la revendication 1 ou 2, dans laquelle la première région comprend une pluralité de troisièmes régions (111) au-dessus de la région active, les troisièmes régions adjacentes dans la pluralité de troisièmes régions sont séparées par une seconde tranchée d'isolation (170), et une profondeur par laquelle la seconde tranchée d'isolation se prolonge dans la région active est supérieure à une profondeur par laquelle la troisième région se prolonge dans la région active.

4. Diode selon l'une quelconque des revendications 1 à 3, dans laquelle une couche barrière (112) est disposée entre la première région et la région active, et la couche barrière est configurée pour ralentir la migration d'un porteur entre la première région et la région active, et dans laquelle la couche barrière et la couche de dérive sont toutes deux dopées soit avec des impuretés acceptrices, soit avec des impuretés donneuses.

5. Diode selon l'une quelconque des revendications 1 à 4, dans laquelle la première résistance est en silicium polycristallin.

6. Diode selon l'une quelconque des revendications 1 à 5, dans laquelle une première couche semi-conductrice (400) est disposée entre la couche de dérive et la première couche d'électrode, la couche de dérive et la première couche semi-conductrice sont toutes deux dopées soit avec des impuretés acceptrices, soit avec des impuretés donneuses, et une concentration de dopage de la première couche semi-conductrice est comprise entre la concentration de dopage de la couche de dérive et la concentration de dopage de la première couche d'électrode.

7. Diode selon l'une quelconque des revendications 1 à 6, dans laquelle au moins un anneau de limitation de champ (321) est disposé dans la région terminale.

8. Diode selon la revendication 7, dans laquelle une plaque de champ métallique (323) est disposée au-dessus de l'anneau de limitation de champ.

9. Diode selon la revendication 8, dans laquelle la diode comprend également une plaque de champ résistive (324) entourant la plaque de champ métallique.

10. Diode selon l'une quelconque des revendications 1 à 9, dans laquelle la diode comprend également un anneau de coupure (322) entourant la partie supérieure de la région terminale.

11. Circuit de puissance, comprenant la diode selon l'une quelconque des revendications 1 à 10 et un transistor bipolaire à grille isolée.
